# FASCICULE DE BREVET EUROPEEN

(11) **EP 1 393 088 B1**
(45) Date de publication et mention de la délivrance du brevet: **19.05.2010**
(21) Numéro de dépôt: 02722351.0
(22) Date de dépôt: 19.03.2002
(51) Int. Cl.: G01R 31/28

(54) **DISPOSITIF DE MAINTIEN D'UN CIRCUIT ELECTRONIQUE DANS UN ETAT PREDETERMINE**
VORRICHTUNG ZUR ERHALTUNG EINER ELEKTRONISCHEN SCHALTUNG IN EINEM VORGEGEBENEN ZUSTAND
DEVICE FOR HOLDING AN ELECTRONIC CIRCUIT IN A PREDETERMINED STATE

(30) Priorité: 21.03.2001 FR 0103845
(43) Date de publication de la demande: 03.03.2004
(73) Titulaire: CENTRE NATIONAL D'ETUDES SPATIALES, 75001 Paris (FR)
(72) Inventeur: PERDU, Philippe, F-31100 Toulouse (FR); DESPLATS, Romain, F-31400 Toulouse (FR)
(74) Mandataire: Habasque, Etienne J. Jean-François
(86) Numéro de dépôt international: PCT/FR2002/000962
(87) Numéro de publication internationale: WO 2002/075340

(56) Documents cités:
- US-A- 4 300 207
- US-A- 4 354 268
- US-A- 5 146 161
- US-A- 5 461 649
- US-A- 5 898 703

## Description

La présente invention concerne un dispositif de maintien d'un circuit électronique dans un état prédéterminé le circuit ayant été préalablement amené dans ledit état prédéterminé par une source d'excitation extérieure propre à appliquer des signaux d'entrée à chaque borne d'entrée dudit circuit électronique.

Il est connu de procéder à une analyse et à une expertise d'un circuit électronique, en particulier d'un circuit intégré alors que celui-ci est dans un état prédéterminé, c'est-à-dire une configuration électrique particulière. Alors que le circuit est dans cet état prédéterminé, il est possible, à l'aide d'un système d'observation, généralement un microscope, de procéder à une analyse des différentes zones en fonctionnement du circuit. Lorsque le circuit est défaillant, une telle observation permet de localiser des défauts.

Toutefois, pour procéder à une telle analyse, il convient d'amener le circuit dans un état prédéterminé, cet état prédéterminé correspondant généralement à un état dans lequel le circuit est défaillant.

Afin d'amener le circuit dans cet état, il est nécessaire d'appliquer une séquence de tests aux bornes du circuit. Cette séquence de tests consiste en une succession de changements d'états aux bornes d'entrée du circuit jusqu'à ce que l'état prédéterminé recherché soit atteint.

Lors de l'analyse du circuit à l'aide du système d'observation, l'état prédéterminé du circuit doit être maintenu pendant toute l'observation. Les moyens permettant de maintenir cet état doivent être compatibles avec des niveaux de courant très faible du circuit, avec une précision de 1 µV et de 100 pA. Ils doivent de plus ne pas engendrer de perturbations rapides de l'ordre de la microseconde..

Pour amener un circuit électronique dans un état prédéterminé et le maintenir celui-ci dans cet état, il est connu de mettre en oeuvre un testeur électrique constituant une source d'excitation extérieure. Le testeur électrique permet d'engendrer de manière autonome la séquence de tests nécessaire pour amener le circuit dans l'état prédéterminé et d'appliquer celle-ci au circuit.

Un tel testeur a un coût très élevé et ne peut être mis en oeuvre simplement avec un équipement d'analyse de défaillance, un microscope par exemple, du fait de son encombrement et des très nombreux circuits qu'il comporte, ces derniers pouvant créer des perturbations dans le résultat des mesures effectuées depuis l'installation d'observation.

Il est également possible de recourir à une boîte de commutation manuelle permettant de modifier les états d'entrée du circuit intégré. L'encombrement réduit de la boîte de commutation manuelle et son caractère passif réduisent les perturbations lors des mesures. Lorsque la séquence de tests est longue, celle-ci pouvant atteindre 1000 changements successifs des états d'entrée du circuit, le maniement des interrupteurs est long et fastidieux.

US 5 461 649 divulgue un dispositif de maintien de l'état d'un automate fini pendant des conditions d'instabilité des signaux d'horloge et sans retard de ces derniers. En plus, US 4 354 268 divulgue une tête de test intelligente pour un système de test automatisé.

L'invention a pour but de proposer un dispositif permettant d'effectuer une observation d'un circuit électronique dans un état prédéterminé, en s'affranchissant des difficultés résultant des moyens mis en oeuvre pour amener le circuit dans cet état prédéterminé.

A cet effet, l'invention a pour objet un dispositif de maintien d'un circuit électronique dans un état prédéterminé comme défini par la revendication 1.

Suivant des modes particuliers de réalisation, le dispositif comporte l'une ou plusieurs des caractéristiques suivantes :
- chaque ligne de connexion comporte un organe de commutation assurant une connexion sélective de l'entrée et de la sortie associées sous la commande desdits moyens de pilotage ;
- il comporte une mémoire de stockage de caractéristiques du signal d'entrée recueilli par lesdits moyens de recueil, pour chaque borne d'entrée du circuit électronique ;
- lesdits moyens autonomes d'excitation permanente comportent un générateur de signaux de maintien comportant deux sorties adaptées pour délivrer un premier signal à une première sortie et un second signal à une seconde sortie, et des moyens de commutation adaptés pour assurer sélectivement, sous la commande desdits moyens de pilotage, la connexion de chaque sortie à l'une ou l'autre des première et seconde sorties du générateur de signaux de maintien ;
- lesdits moyens autonomes d'excitation comportent des moyens de commutation adaptés pour assurer sélectivement, sous la commande des moyens de pilotage, la déconnexion de chaque sortie de l'une et l'autre des sorties du générateur de signaux de maintien et pour l'établissement d'une haute impédance à la sortie associée ; et
- il comporte des moyens autonomes d'alimentation.

L'invention sera mieux comprise à la lecture de la description qui va suivre, donnée uniquement à titre d'exemple et faite en se référant aux dessins, sur lesquels :
- la figure 1 est une vue schématique du dispositif selon l'invention relié à un testeur électrique et à un circuit électronique, lors de la phase d'excitation du circuit vers un état prédéterminé ;
- la figure 2 est un organigramme explicitant le fonctionnement du dispositif de la figure 1 ; et
- la figure 3 est une vue schématique du dispositif selon l'invention lors d'une phase d'observation du circuit électrique.

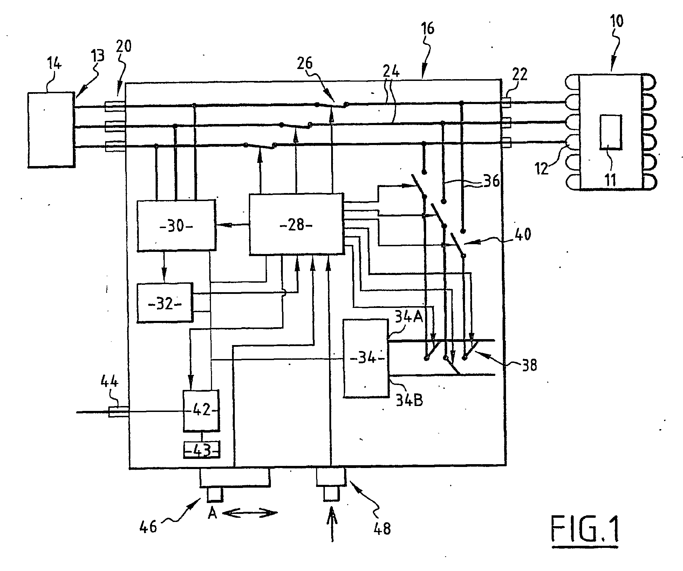

Sur la figure 1 est représenté un circuit électronique à tester 10, ce circuit comportant un circuit intégré 11. Les bornes d'entrée 12 du circuit électronique 10 sont reliées aux sorties 13 d'un testeur électrique 14 au travers d'un dispositif de maintien16 selon l'invention.

Le testeur électrique 14 est de tout type connu en soi. Il comporte par exemple deux cent cinquante six sorties 13 destinées à être reliées chacune à une entrée du circuit électronique 10.

Le testeur électrique est adapté pour engendrer une séquence de tests prédéterminée permettant d'appliquer une succession de vecteurs de test aux bornes d'entrée 12 du circuit 10.

Chaque sortie 13 du testeur électrique est adapté pour produire trois états logiques différents, un état bas (0), un état haut (1) et un état (HI) imposant une haute impédance à l'entrée associée du circuit.

Le dispositif de maintien 16 selon l'invention présente deux cent cinquante six bornes d'entrée 20, chacune reliée par un conducteur à une sortie de commande 18 du testeur électrique 14.

En outre, le dispositif de maintien 16 comporte deux cent cinquante six bornes de sortie 22, chacune reliée par un conducteur, à une borne d'entrée 12 du circuit à tester.

Sur les figures, seules trois bornes d'entrée 20 et de sorties 22 sont représentées pour des raisons de clarté.

Chaque borne d'entrée 20 est reliée à une borne de sortie 22 par une ligne de liaison propre 24. Cette ligne est équipée seulement d'un organe de commutation propre 26 permettant de connecter sélectivement la borne d'entrée à la borne de sortie associée.

Chaque organe de commutation 26 est relié, pour sa commande individuelle, à une unité centrale de pilotage 28.

Cette unité centrale de pilotage comporte par exemple un microprocesseur associé à un environnement adapté pour la mise en oeuvre d'algorithmes de commande stockés dans une mémoire.

Le dispositif comporte des moyens de lecture 30 reliés à chaque entrée 20 du dispositif. Les moyens de lecture 30 sont adaptés pour recueillir le signal d'entrée reçu du testeur électrique 14 sur chacune des entrées 20 du dispositif.

En particulier, les moyens de lecture 30 sont adaptés pour recueillir les paramètres caractéristiques du signal d'entrée imposé par le testeur 14. Ils déterminent notamment si ce signal d'entrée correspond à un état haut (1), un état bas (0) ou un état de haute impédance (HI).

Les moyens de lecture 30 sont commandés par l'unité centrale de pilotage 28.

Les moyens de lecture 30 sont reliés à une mémoire 32 adaptée pour stocker, pour chaque entrée 20, les caractéristiques du signal d'entrée recueilli par les moyens de lecture 30.

Par ailleurs, le dispositif 16 comporte un générateur 34 de signaux de maintien.

Ce générateur est propre au dispositif 16. Il comporte deux sorties 34A, 34B. Il est adapté pour délivrer de manière continue sur la première sortie 34A un signal de maintien correspondant à un état bas (0) et, sur sa seconde sortie 34B, un signal correspond à un état haut (1).

Chaque sortie 22 du dispositif 16 est relié par une ligne individuelle 36 à un premier organe de commutation 38 assurant, sous la commande de l'unité centrale de pilotage 28, la liaison de la sortie associée 22 à l'une ou l'autre des sorties 34A et 34B du générateur de signaux de maintien.

Chaque ligne de liaison 36 comporte un second organe de commutation 40 commandé par l'unité centrale de pilotage 28, cette organe de commutation 40 assure la connexion sélective de chaque sortie aux bornés de sortie 22 du générateur de signaux de maintien 34 au travers du premier organe de commutation 38 associé.

L'unité centrale de pilotage 28, les moyens de lecture 30, la mémoire 32 et le générateur 34 de signaux de maintien sont tous reliés à une unité d'alimentation 42 intégrée au dispositif de maintien 16. Cette unité d'alimentation 42 présente des moyens 43 de stockage d'énergie, tels que des accumulateurs permettant une alimentation autonome des organes fonctionnels du dispositif de maintien. L'unité d'alimentation 42 comporte en outre une entrée 44 permettant sa liaison à un réseau de distribution d'énergie extérieure permettant la fourniture d'énergie aux différents organes de l'unité et en particulier la recharge des moyens de stockage 43.

Le dispositif 16 comporte en outre des moyens de commande pour un utilisateur. Ceux-ci comportent un sélecteur 46 à deux états. Ce sélecteur est relié à l'unité centrale de pilotage 28. En outre, un contact 48, relié à l'unité centrale de pilotage 28, permet de communiquer un ordre de lecture et de mémorisation à cette unité centrale.

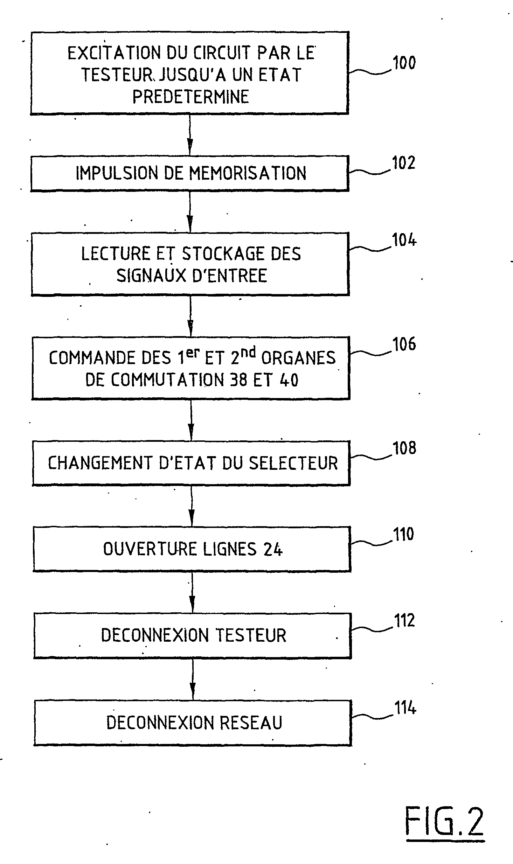

Le dispositif de maintien 16 fonctionne sous la commande de l'unité centrale de pilotage 28 mettant en oeuvre un algorithme adapté, comme illustré sur l'organigramme de la figure 2.

Initialement, le dispositif est dans un état illustré sur la figure 1, Il est avantageusement connecté sur une source de tension extérieure depuis son entrée 44.

Le sélecteur 46 est placé dans une première position A de sorte que l'unité centrale de pilotage 28 impose la fermeture de chacun des organes de commutation 26.

Le dispositif de maintien est alors relié en série entre chacune des sorties 13 du testeur et les entrées 12 correspondantes du circuit 10. Ainsi, les entrées 20 du dispositif selon l'invention sont reliées aux sorties 13 du testeur alors que les sorties 22 sont reliées aux entrées 12 du circuit.

Les organes de commutation 16 étant passant, une liaison directe est établie entre les sorties 13 du testeur et les entrées 12 du circuit.

A partir du testeur 14, et comme connu en soi, une séquence de tests est appliquée aux entrées 12 du circuit pour amener celui-ci jusqu'à un état prédéterminé, à l'étape 100.

A l'étape 102, l'opérateur enfonce le contact 48 afin d'adresser à l'unité centrale de pilotage 28 une impulsion de mémorisation.

En variante, l'impulsion de mémorisation est générée automatiquement par l'unité centrale de pilotage 28 à l'issue de la séquence de test.

Suite à la réception de cette impulsion de mémorisation, l'unité centrale de pilotage 28 commande, à l'étape 104, les moyens de lecture 30 afin que ceux-ci recueillent les caractéristiques du signal d'entrée fourni par chaque sortie du testeur 14 à l'entrée associée du circuit 10. Les caractéristiques de ces signaux d'entrée sont stockés dans la mémoire 32.

A l'issue de ce recueil et de ce stockage des signaux d'entrée, l'unité centrale de pilotage 28 commande, à l'étape 106, les premier et second organes de commutation 38, 40 afin de relier chaque sortie 22 du dispositif à l'une des sorties 34A, 34B du générateur de signaux de maintien 34, ou de maintenir ces sorties sans connexion.

En particulier, lorsque le signal de commande appliqué sur une entrée 10 du circuit par le testeur est un signal (HI) correspondant à une haute impédance, l'organe de commutation 40 est maintenu ouvert. L'organe de commutation 38 associé à la sortie concernée n'est pas commandé et est maintenu dans son état précédent.

En revanche, si le signal d'entrée appliqué à la borne du circuit est à un état bas (0) ou un état haut (1), l'organe de commutation 40 de la ligne associée est fermé. L'organe de commutation 38 est commandé afin de connecter la sortie 22 à la sortie 34A du générateur de signaux de maintien 34 si le signal d'entrée du circuit doit correspondre à un état bas (0) et à la sortie 34B si le signal d'entrée doit correspondre à un état haut (1).

L'état des organes de commutation 38 et 40 est résumé en fonction des signaux d'entrée appliqués au circuit dans le tableau 1 figurant ci-dessous :

**TABLEAU 1**

| Signal d'entrée | Organe de commutation 40 | Organe de commutation 38 |
|---|---|---|
| Bas (0) | Fermé | Sortie 34A |
| Haut (1) | Fermé | Sortie 34B |
| Haute impédance (HI) | Ouvert | non commandé |

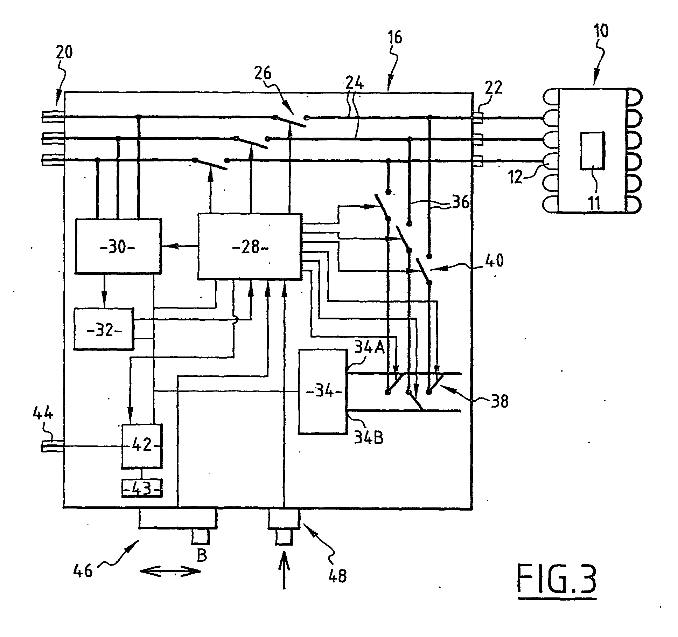

A l'étape 108, l'opérateur amène le sélecteur 46 dans sa seconde position illustrée sur la figure 3. En réponse, l'unité centrale de pilotage désactive les moyens de lecture 30 et cesse l'alimentation de la mémoire 32. De plus, elle commande l'unité d'alimentation 42 afin que celle-ci assure une alimentation autonome des organes fonctionnels en marche, à partir de l'énergie stockée dans les moyens 43.

En particulier, l'unité centrale de pilotage 28 et le générateur de signaux de maintien 34 sont ainsi alimentés.

De plus, à l'étape 110, l'unité centrale de pilotage 28 commande l'ouverture des organes de commutation 26 afin de provoquer la déconnexion du testeur 14 et du circuit 10.

Aux étapes 112 et 114, l'opérateur procède à la déconnexion physique du testeur 14 et de l'entrée d'alimentation 14 depuis le réseau de distribution extérieure.

Ainsi, le dispositif de maintien est dans l'état illustré sur la figure 3.

On comprend que le générateur de signaux de maintien 34, connectés de manière adaptée au travers des organes de commutation 38 et 40 aux différentes entrées du circuit 10 permet de maintenir le circuit 10 dans son état prédéterminé en l'absence du testeur électrique 14, les signaux d'entrée initialement imposés par le testeur 14 étant reproduits par le générateur de signaux de maintien 34.

Le circuit 10, ainsi connecté au dispositif de maintien rendu autonome après sa déconnexion du réseau d'alimentation extérieur peut être transporté jusqu'à une installation d'observation afin de procéder à une analyse des éléments constituant le circuit intégré 11 dans l'état prédéterminé dans lequel est maintenu le circuit.

Le faible nombre d'éléments constituant le dispositif de maintien permet que celui-ci soit d'un encombrement et d'un coût réduits.

## Revendications

1. Dispositif (16) électronique de maintien d'un circuit électronique (10) dans un état prédéterminé, le circuit (10) ayant été préalablement amené dans ledit état prédéterminé par une source d'excitation extérieure (14) propre à appliquer des signaux d'entrée à chaque borne, d'entrée (12) dudit circuit électronique (10), **caractérisé en ce que** le dispositif électronique de maintien comporte :
- des moyens (30) de recueil du signal d'entrée appliqué, par ladite source d'excitation extérieure (14), à chaque borne d'entrée (12) du circuit électronique dans ledit état prédéterminé ;
- des moyens autonomes (34, 38, 40) d'excitation permanente du circuit électronique (10) adaptés pour le maintien, après suppression de ladite source d'excitation extérieure (14), à chaque borne d'entrée (12) du circuit électronique, du signal d'entrée recueillir ; et
- des moyens (28) de pilotage des moyens autonomes (34, 38, 40) d'excitation permanente en fonction du signal d'entrée recueilli;
- pour chaque borne d'entrée (12) du circuit électronique (10), une entrée (20) de connexion pour la source d'excitation extérieure (14) et une sortie (22) de connexion pour une borne d'entrée (12) du circuit électronique (10), et une ligne de liaison (24) reliant chaque entrée (20) à une sortie (22) pour permettre le montage du dispositif électronique de maintien (16) en série entre la source d'excitation extérieure (14) et le circuit électronique (10).

2. Dispositif selon la revendication 1, **caractérisé en ce que** chaque ligne de liaison (24) comporte un organe de commutation (26) assurant une connexion sélective de l'entrée (20) et de la sortie (22) associées sous la commande desdits moyens de pilotage (28).

3. Dispositif selon l'une quelconque des revendications précédentes, **caractérisé en ce qu'**il comporte une mémoire (32) de stockage de caractéristiques du signal d'entrée recueilli par lesdits moyens de recueil (30), pour chaque borne d'entrée (12) du circuit électronique (10).

4. Dispositif selon l'une quelconque des revendications précédentes, **caractérisé en ce que** lesdits moyens autonomes d'excitation permanente comportent un générateur de signaux de maintien (34) comportant deux sorties (34A, 34B) adaptées pour délivrer un premier signal à une première sortie (34A) et un second signal à une seconde sortie (34B), et des moyens de commutation (38) adaptés pour assurer sélectivement, sous la commande desdits moyens de pilotage (28), la connexion de chaque sortie (22) à l'une ou l'autre des première et seconde sorties (34A, 34B) du générateur de signaux de maintien (34).

5. Dispositif selon la revendication 5, **caractérisé en ce que** lesdits moyens autonomes d'excitation comportent des moyens de commutation (40) adaptés pour assurer sélectivement, sous la commande des moyens de pilotage (28), la déconnexion de chaque sortie (22) de l'une et l'autre des sorties (34A, 34B) du générateur de signaux de maintien (34) et pour l'établissement d'une haute impédance à la sortie (22) associée.

6. Dispositif selon l'une quelconque des revendications précédentes, **caractérisé en ce qu'**il comporte des moyens autonomes (42, 43) d'alimentation.

## Claims

1. Electronic device (16) for holding an electronic circuit (10) in a predetermined state, the circuit (10) having previously been brought into the said predetermined state by an external source of excitation (14) adapted to apply input signals to each input terminal (12) of the said electronic circuit (10), **characterised in that** the electronic holding device comprises:
- means (30) for receiving the input signal applied from the said external source of excitation (14) to each input terminal (12) of the electronic circuit in the said predetermined state;
- independent means (34, 38, 40) for permanent excitation of the electronic circuit (10) adapted for holding, after suppression of the said external source of excitation (14), the received input signal at each input terminal (12) of the electronic circuit; and
- means (28) for controlling the independent means (34, 38, 40) for permanent excitation as a function of the received input signal;
- for each input terminal (12) of the electronic circuit (10), an input (20) for connection to the external source of excitation (14) and an output (22) for connection to an input terminal (12) of the electronic circuit (10), and a link line (24) connecting each input (20) to an output (22) allowing the connection in series of the electronic holding device (16) with the external source of excitation (14) and the electronic circuit (10).

2. Device according to claim 1, **characterised in that** each link line (24) comprises a switch member (26) providing a selective connection between the input (20) and the output (22) associated under the command of the said control means (28).

3. Device according to any of the preceding claims, **characterised in that** it comprises a memory (32) for holding the characteristics of the input signal received from the said receiving means (30), for each input terminal (12) of the electronic circuit (10).

4. Device according to any of the preceding claims, **characterised in that** the said independent means for permanent excitation comprises a holding signal generator (34) comprising two outputs (34A, 34B) adapted to deliver a first signal to a first output (34A) and a second signal to a second output (34B), and switch means (38) adapted to provide selectively, under the command of the said control means (28), the connection of each output (22) with one or the other of the first and second outputs (34A, 34B) of the holding signal generator (34).

5. Device according to claim 5, **characterised in that** the said independent means for excitation comprise switch means (40) adapted to provide selectively, under the command of the control means (28), the disconnection of each output (22) from one or the other of the output (34A, 34B) of the holding signal generator (34) and for establishing a high impedance at the associated output (22).

6. Device according to any of the preceding claims, **characterised in that** it comprises independent supply means (42, 43).

## Patentansprüche

1. Elektronische Vorrichtung (16) zur Aufrechterhaltung eines vorgegebenen Zustands einer elektronischen Schaltung (10) - wobei die Schaltung (10) vorher in den vorgegebenen Zustand gebracht worden ist -, durch eine äußere Erregungsquelle (14), fähig Eingangssignale an jeden Eingangskontakt (12) der genannten elektronischen Schaltung (10) zu legen,
**dadurch gekennzeichnet, dass** die genannte elektronische Aufrechterhaltungsvorrichtung umfasst:
- Empfangseinrichtungen (30) des an jeden Eingangsanschluss (12) der elektronischen Schaltung in dem genannten vorgegebenen Zustand angelegten Eingangssignals durch die genannte äußere Erregungsquelle (14);
- autonome Permanenterregungseinrichtungen (34, 38, 40) der elektronischen Schaltung (10), angepasst um nach dem Wegfall der genannten äußeren Erregungsquelle (14) an jedem Eingangsanschluss (12) der elektronischen Schaltung das empfangene Eingangssignal aufrechtzuerhalten; und
- Einrichtungen (28) zum Steuern der autonomen Permanenterregungseinrichtungen (34, 38, 40) in Abhängigkeit von dem empfangenen Eingangssignal;
- für jeden Eingangsanschluss (12) der elektronischen Schaltung (10) einen Verbindungseingang (20) für die äußere Erregungsquelle (14) und einen Verbindungsausgang (22) für einen Eingangsanschluss (12) der elektronischen Schaltung (10), und eine Verbindungsleitung (24), die jeden Eingang (20) mit einem Ausgang (22) verbindet, um eine Reihenschaltung der elektronischen Aufrechterhaltungsvorrichtung (16) zwischen der äußeren Erregungsquelle (14) und der elektronischen Schaltung (10) zu ermöglichen.

2. Vorrichtung nach Anspruch 1, **dadurch gekennzeichnet, dass** jede Verbindungsleitung (24) ein Schaltorgan (26) umfasst, das eine selektive Verbindung des Eingangs (20) und des zugeordneten Ausgangs (22) gewährleistet, gesteuert durch die genannten Steuereinrichtungen (28).

3. Vorrichtung nach einem der vorhergehenden Ansprüche, **dadurch gekennzeichnet, dass** sie für jeden Eingangsanschluss (12) der elektronischen Schaltung (10) einen Speicher (32) zur Einspeicherung der Charakteristika des durch die genannten Empfangseinrichtungen (30) empfangenen Eingangssignals umfasst.

4. Vorrichtung nach einem der vorhergehenden Ansprüche, **dadurch gekennzeichnet, dass** die genannten autonomen Permanenterregungseinrichtungen umfassen: einen Generator von Aufrechterhaltungssignalen (34) mit zwei Ausgängen (34A, 34B), angepasst um an einem ersten Ausgang (34A) ein erstes Signal und an einem zweiten Ausgang (34B) ein zweites Signal zu liefern, und Schalteinrichtungen (38), angepasst um unter der Kontrolle der genannten Steuereinrichtungen (28) selektiv die Verbindung jedes Ausgangs (22) mit dem einen oder dem anderen der Ausgänge (34A, 34B) des Aufrechterhaltungssignalgenerators (34) herzustellen.

5. Vorrichtung nach Anspruch 5, **dadurch gekennzeichnet, dass** die genannten autonomen Erregungseinrichtungen Schalteinrichtungen (40) umfassen, angepasst um unter der Kontrolle der Steuereinrichtungen (28) selektiv die Trennung jedes Ausgangs (22) von dem einen oder dem anderen der Ausgänge (34A, 34B) des Aufrechterhaltungssignalgenerators (34) sicherzustellen und an dem zugeordneten Ausgang (22) eine hohe Impedanz herzustellen.

6. Vorrichtung nach einem der vorhergehenden Ansprüche, **dadurch gekennzeichnet, dass** sie autonome Versorgungseinrichtungen (42, 43) umfasst.
